# FASCICULE DE BREVET EUROPEEN

(11) **EP 3 714 668 B1**
(45) Date de publication et mention de la délivrance du brevet: **21.06.2023**
(21) Numéro de dépôt: 18807234.2
(22) Date de dépôt: 14.11.2018
(51) Int. Cl.: H05K 7/20, B60H 1/14, B60H 1/00

(54) **DISPOSITIF D'ÉVACUATION DE LA CHALEUR ÉMISE PAR UN BOÎTIER ÉLECTRONIQUE**
VORRICHTUNG ZUM ABFÜHREN DER VON EINER ELEKTRONISCHEN EINHEIT ABGEGEBENEN WÄRME
DEVICE FOR DISCHARGING HEAT EMITTED BY AN ELECTRONIC UNIT

(30) Priorité: 21.11.2017 FR 1760993
(43) Date de publication de la demande: 30.09.2020
(73) Titulaire: Renault s.a.s, 92100 Boulogne Billancourt (FR)
(72) Inventeur: JUVIN, Alexis, 92240 Malakoff (FR); GUIGNARD, Fabrice, 78280 Guyancourt (FR)
(74) Mandataire: Renault Group
(86) Numéro de dépôt international: PCT/EP2018/081180
(87) Numéro de publication internationale: WO 2019/101591

(56) Documents cités:
- AU-A- 3 152 771
- US-A- 5 706 170
- US-A- 5 937 664
- US-A- 5 979 540

## Description

L'invention porte sur un dispositif d'évacuation de la chaleur émise par au moins un boîtier électrique et/ou électronique implanté au sein d'une planche de bord de véhicule automobile. L'invention porte aussi sur un agencement comprenant un tel dispositif d'évacuation au sein d'une planche de bord de véhicule automobile. L'invention porte encore sur un procédé d'évacuation de la chaleur d'au moins un boîtier électrique et/ou électronique. L'invention porte également sur un programme d'ordinateur mettant en oeuvre un tel procédé. L'invention porte également sur un support d'enregistrement sur lequel est enregistré un tel programme d'ordinateur. L'invention porte enfin sur un véhicule automobile équipé d'un tel dispositif d'évacuation ou d'un tel agencement.

L'espace au sein d'une planche de bord de véhicule automobile est encombré, en particulier du fait de la présence d'un ou plusieurs boîtiers électriques et/ou électroniques tels que par exemple des calculateurs. En plus d'occuper un volume non négligeable dans cet espace confiné, ces boîtiers y génèrent de la chaleur due à la puissance thermique dissipée. Ainsi la température au sein de la planche de bord peut être importante, en particulier lorsque la température extérieure est élevée. Il peut arriver que la température d'un boîtier électrique et/ou électronique atteigne une température trop importante engendrant son dysfonctionnement ou son passage en mode de fonctionnement dégradé, le boîtier ne disposant alors que de certaines fonctions restreintes.

Les documents US5979540, AU3152771, US5937664 et US5706170 montrent les solutions différentes pour refroidissement d'électronique dans une voiture.

Le but de l'invention est de fournir un dispositif d'évacuation de la chaleur d'au moins un boîtier électrique et/ou électronique remédiant aux inconvénients ci-dessus. En particulier, l'invention permet un agencement d'un dispositif d'évacuation de la chaleur ayant un encombrement réduit au sein de la planche de bord et étant simple à mettre en place.

Pour atteindre cet objectif, l'invention porte sur un dispositif d'évacuation de la chaleur selon la revendication 1.

Le dispositif d'évacuation comprend un premier diffuseur agencé au niveau de l'extrémité ouverte du conduit d'évacuation de sorte à permettre la diffusion de la chaleur à l'extérieur d'un véhicule automobile.

Le premier diffuseur peut comprendre un clapet anti-retour, notamment un clapet anti-retour de type volet, de sorte à permettre uniquement un flux d'air depuis le volume intérieur du conduit d'évacuation vers l'extérieur.

Le dispositif d'évacuation comprend un deuxième diffuseur agencé au niveau de l'extrémité ouverte du conduit d'évacuation de sorte à permettre la diffusion de la chaleur au sein d'un habitacle du véhicule automobile.

Le dispositif d'évacuation comprend un élément de bifurcation apte à orienter le flux d'air depuis le volume intérieur du conduit d'évacuation vers le premier diffuseur et/ou vers le deuxième diffuseur, notamment un élément de bifurcation qui peut comprendre au moins un volet.

L'invention porte encore sur un agencement au niveau d'une planche de bord de véhicule automobile comprenant une traverse tubulaire, notamment une traverse tubulaire s'étendant ou s'étendant sensiblement depuis un montant droit de pare-brise jusqu'à un montant gauche de pare-brise, l'agencement comprenant un dispositif d'évacuation tel que défini précédemment, la traverse tubulaire faisant office de conduit d'évacuation. L'agencement peut comprendre un raccord s'étendant transversalement ou sensiblement transversalement dans le prolongement de la traverse tubulaire depuis l'extrémité ouverte de la traverse tubulaire jusqu'au premier diffuseur, ou sensiblement jusqu'au premier diffuseur, notamment un raccord recevant l'élément de bifurcation.

Le ventilateur peut être disposé au sein de la traverse tubulaire et/ou au sein du raccord et/ou au sein de l'élément de bifurcation.

L'agencement peut comprendre au moins un boîtier électrique et/ou électronique et au moins une goulotte s'étendant entre au moins un boîtier électrique et/ou électronique et au moins un orifice radial de la traverse tubulaire de sorte à guider la chaleur depuis au moins un boîtier électrique et/ou électronique vers le volume intérieur de la traverse tubulaire.

L'invention porte encore sur un procédé d'évacuation de la chaleur selon la revendication 8.

Le procédé comprend une étape de détermination d'une requête de refroidissement ou d'une requête de chauffage faite au sein de l'habitacle, et,
en cas de requête de refroidissement, alors au moins un volet de l'élément de bifurcation s'ouvre en vis-à-vis ou sensiblement en vis-à-vis du premier diffuseur, et,
en cas de requête de chauffage, alors au moins un volet de l'élément de bifurcation s'ouvre en vis-à-vis ou sensiblement en vis-à-vis du deuxième diffuseur.

L'invention porte encore sur un agencement tel que défini précédemment, l'agencement comprenant des éléments matériels et/ou logiciels mettant en oeuvre le procédé tel que défini précédemment.

L'invention porte encore sur un produit programme d'ordinateur téléchargeable depuis un réseau de communication et/ou enregistré sur un support de données lisible par un calculateur et/ou exécutable par un calculateur, le produit programme d'ordinateur comprenant des instructions de code de programme informatique de mise en oeuvre du procédé tel que défini précédemment, lorsque le programme est exécuté par un calculateur.

L'invention porte encore sur un support d'enregistrement de données, lisible par un calculateur, sur lequel est enregistré un programme d'ordinateur comprenant des instructions de code de programme de mise en oeuvre du procédé tel que défini précédemment.

L'invention porte enfin sur un véhicule automobile comprenant un dispositif d'évacuation tel que défini précédemment et/ou un agencement tel que défini précédemment.

Les figures annexées représentent, à titre d'exemple, un premier mode de réalisation d'un agencement et des variantes de ce premier mode et un deuxième mode de réalisation d'un agencement.
La figure 1 représente une vue de dessus schématique d'un véhicule automobile selon un mode de réalisation.
La figure 2 représente une vue de côté partielle schématique d'un agencement selon un premier ou un deuxième mode de réalisation.
La figure 3 représente une vue en perspective partielle de l'agencement selon le premier mode de réalisation.
La figure 4 représente une vue de détail en perspective de l'agencement selon le premier mode de réalisation.
La figure 5a représente une vue en coupe selon un plan vertical et longitudinal de l'agencement selon le premier ou le second mode de réalisation.
La figure 5b représente une vue en coupe selon un plan vertical et longitudinal d'un détail de l'agencement selon le premier ou le second mode de réalisation.
La figure 6 représente une vue en perspective d'une goulotte selon un mode de réalisation.
La figure 7 représente une vue partielle en perspective de l'agencement selon le premier ou le second mode de réalisation.
La figure 8 représente une vue de dessus schématique de l'agencement selon le premier mode de réalisation, l'évacuation étant obligatoirement dirigée vers l'extérieur.
La figure 9 représente une vue de dessus schématique d'un agencement selon une variante du premier mode de réalisation, l'évacuation étant obligatoirement dirigée vers l'habitacle.
La figure 10 représente une vue partielle en perspective d'un agencement selon un deuxième mode de réalisation.
La figure 11 représente une vue en perspective d'un raccord et d'un premier diffuseur de l'agencement selon le deuxième mode de réalisation.
La figure 12 représente une vue en perspective du raccord de l'agencement selon le deuxième mode de réalisation.
Les figures 13 et 14 représentent des vues de face du raccord de l'agencement selon le deuxième mode de réalisation, en position d'évacuation vers l'extérieur.
Les figures 15, 16 et 17 représentent des vues en perspective du raccord de l'agencement selon le deuxième mode de réalisation, en position d'évacuation vers l'habitacle.
La figure 18 représente une vue en perspective d'un volet de bifurcation de l'agencement selon le deuxième mode de réalisation.
Les figures 19, 20 et 21 représentent des vues en perspective du premier diffuseur de l'agencement selon le deuxième mode de réalisation.
Les figures 22 et 23 représentent des vues de dessus schématiques d'un agencement selon une autre variante du premier mode de réalisation.

La direction selon laquelle un véhicule automobile se déplace habituellement en ligne droite est définie comme étant la direction longitudinale. Par convention, la direction perpendiculaire à la direction longitudinale, située dans un plan parallèle au sol, est nommée direction transversale. La troisième direction, perpendiculaire aux deux autres, est nommée direction verticale.

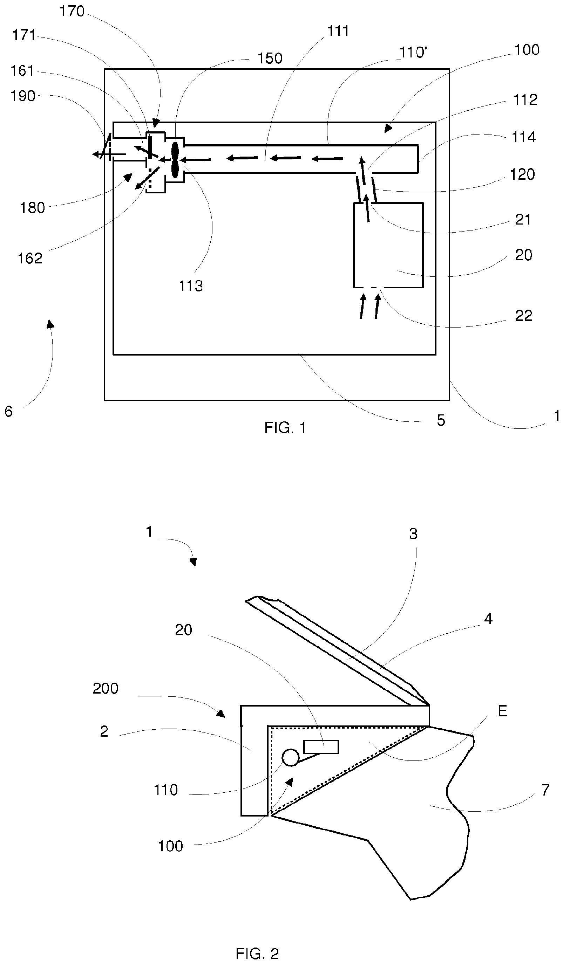

Comme illustré sur la figure 1, un véhicule automobile 1 comprend un dispositif d'évacuation 100 destiné à évacuer la chaleur produite par le fonctionnement d'un boîtier électrique et/ou électronique 20. Le dispositif d'évacuation 100 comprend un ventilateur 150 et un conduit d'évacuation 110'. Le conduit d'évacuation 110' est doté d'un orifice radial 112 de sorte à permettre à la chaleur émise par le boîtier 20 d'entrer au sein d'un volume intérieur 111 du conduit d'évacuation 110'. De préférence, une ou plusieurs arrivées d'air 22, par exemple au nombre de deux, sont ménagées dans le boîtier 20, par exemple sur une face opposée à la face comprenant une sortie d'air 21, en vis-à-vis ou sensiblement en vis-à-vis de l'orifice radial 112. Une extrémité ouverte 113 du conduit d'évacuation 110' est destinée à évacuer la chaleur du volume intérieur 111. L'autre extrémité 114 du conduit d'évacuation 110' est obstruée intégralement.

Le dispositif d'évacuation 100 comprend un premier diffuseur 161 agencé à proximité de l'extrémité ouverte 113 du conduit d'évacuation 110'. Le premier diffuseur 161 est par exemple disposé à proximité de l'extérieur 6 du véhicule automobile 1. Du fait de cette proximité avec l'extérieur 6, le premier diffuseur 161 comprend de préférence un clapet anti-retour 190, par exemple un clapet anti-retour de type volet, c'est-à-dire doté d'un ou plusieurs volets apte à pivoter autour d'un ou plusieurs axes horizontaux ou sensiblement horizontaux. De préférence, le clapet anti-retour 190 a deux positions, ouverte et fermée.

Le dispositif d'évacuation 100 comprend également un deuxième diffuseur 162 agencé à proximité de l'extrémité ouverte 113 du conduit d'évacuation 110'. Le deuxième diffuseur 162 peut être disposé ailleurs, du moment qu'il se trouve à proximité d'un habitacle 5 du véhicule automobile 1.

Le dispositif d'évacuation 100 comprend un élément de bifurcation 170 ou d'aiguillage, disposé à proximité du premier diffuseur 161 et/ou du deuxième diffuseur 162. Cet élément de bifurcation 170 comprend avantageusement au moins un volet 171.

Comme il sera détaillé par la suite, une goulotte 120 s'étend de préférence entre le boîtier 20 et le conduit d'évacuation 110'. De plus, un raccord 180 s'étend par exemple entre une extrémité ouverte 113 de conduit d'évacuation 110' et le clapet anti-retour 190.

Un agencement 200 selon un premier ou un deuxième mode de réalisation est illustré sur la figure 2. Cet agencement 200 comprend le dispositif d'évacuation 100 et est disposé au sein d'une planche de bord 2 du véhicule automobile 1. Une traverse tubulaire 110, par exemple une traverse tubulaire 110 s'étendant ou s'étendant sensiblement transversalement depuis un montant droit 3 de pare-brise 4 jusqu'à un montant gauche de pare-brise participe au support de la planche de bord 2. Alternativement la traverse tubulaire 110 s'étend, ou s'étend sensiblement, depuis un pied avant droit jusqu'à un pied avant gauche. La traverse tubulaire 110 comprend des éléments généralement métalliques assemblés entre eux, par exemple par soudure. En plus de renforcer la structure du véhicule automobile 1, la traverse tubulaire 110 assure le maintien du ou des boîtiers électriques et/ou électroniques 20, comme par exemple des calculateurs. Le boîtier 20 peut être implanté au sein d'un espace E, entre la planche de bord 2 et un compartiment moteur avant 7 ou un coffre avant pour un véhicule automobile ne disposant pas de motorisation à l'avant par exemple.

La traverse tubulaire 110 fait alors avantageusement office de conduit d'évacuation 110' du dispositif d'évacuation 100 et remplit ainsi une fonction supplémentaire de conduite de chaleur. Bien que la traverse tubulaire 110 soit de préférence de section circulaire, sa section peut être carrée, rectangulaire, ovale ou d'une autre forme. De plus, la traverse tubulaire 110 peut comprendre plusieurs parties, de sections et/ou de tailles différentes, par exemple assemblées les unes au bout des autres.

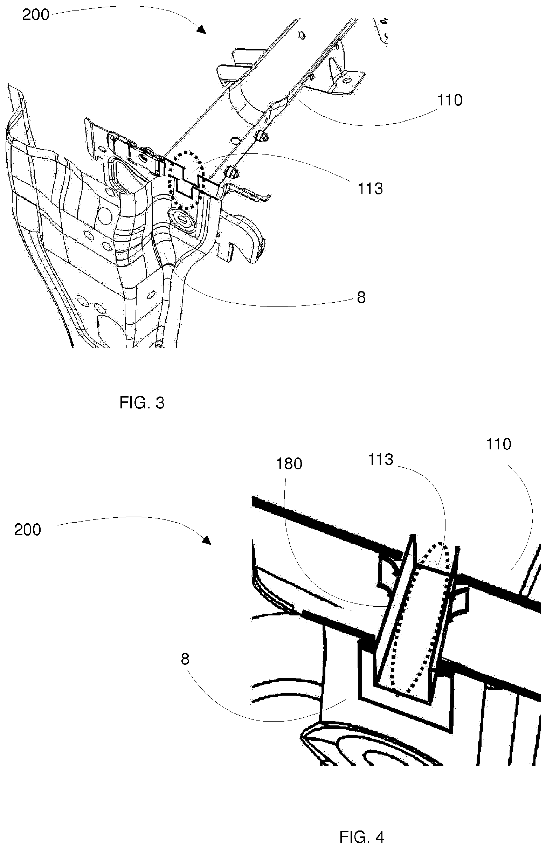

Comme illustré sur les figures 3 et 4, l'agencement 200 comprend avantageusement un raccord 180 s'étendant transversalement ou sensiblement transversalement dans le prolongement de la traverse tubulaire 110, du côté de son extrémité ouverte 113. Le raccord 180 est tubulaire, par exemple de section circulaire. Le raccord 180 s'étend par exemple depuis l'extrémité ouverte 113 de la traverse tubulaire 110 jusqu'au premier diffuseur 161, ou sensiblement jusqu'au premier diffuseur 161, par exemple jusqu'à un pied avant 8, par exemple en tôle, de la caisse du véhicule automobile 1. Avantageusement, le raccord 180 reçoit l'élément de bifurcation 170.

Le ventilateur 150 est par exemple placé au sein de la traverse tubulaire 110, par exemple à proximité de son extrémité ouverte 113. Le ventilateur 150 peut être placé également au sein de l'élément de bifurcation 170. Dans ces configurations, la traverse tubulaire 110 ou l'élément de bifurcation 170 sont de préférence de section circulaire et ont un diamètre intérieur supérieur au diamètre extérieur du ventilateur 150, leur section interne étant coaxiale ou sensiblement coaxiale au ventilateur 150.

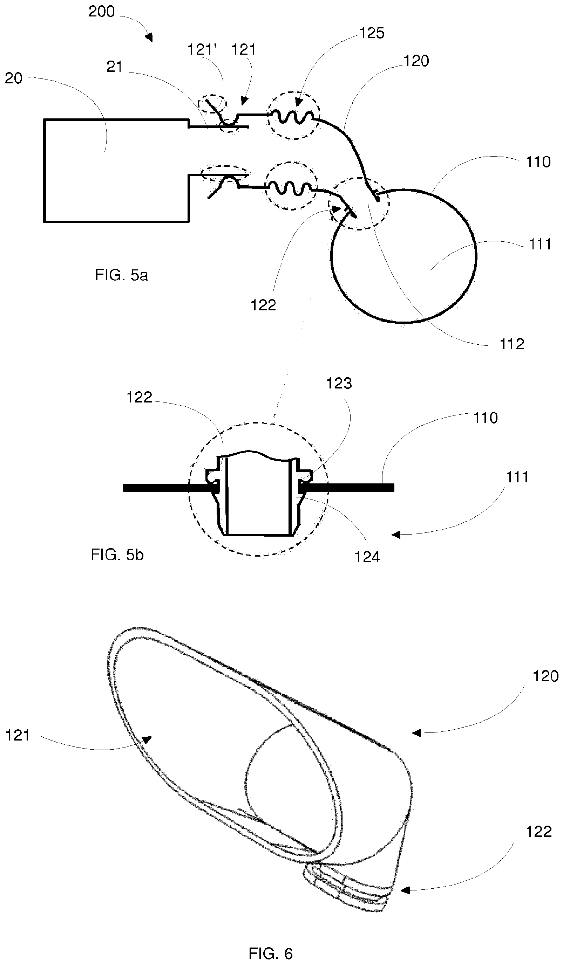

Comme illustré sur la figure 5a, l'agencement 200 comprend le boîtier électrique et/ou électronique 20 et la goulotte 120 correspondante. La goulotte 120 s'étend entre le boîtier 20 et l'orifice radial 112 de la traverse tubulaire 110. Ainsi, une entrée 121 de la goulotte 120 est destinée à coïncider avec la sortie d'air 21 du boîtier 20 tandis qu'une sortie 122 de la goulotte 120 coïncide avec l'orifice radial 112 de la traverse tubulaire 110. Par « coïncider », on entend que la sortie d'air 21 du boîtier 20 entre dans l'entrée 121 de la goulotte 120 et que la sortie 122 de la goulotte 120 entre dans l'orifice radial 112, et ce de manière ajustée sans jeu ou avec un jeu négligeable. Avantageusement la goulotte 120 est en matière déformable, au moins au niveau de son entrée 121 et de sa sortie 122. L'entrée 121 peut comprendre une partie avaloir 121' c'est-à-dire un profil incliné facilitant l'insertion de la goulotte 120 sur le boîtier 20. De préférence la sortie 21 du boîtier 20 comprend une zone, par exemple plane, sur une longueur de 5 mm à 40 mm par exemple, sur laquelle l'entrée 121 de la goulotte 120 peut coulisser tout en assurant l'étanchéité entre la goulotte et le boîtier 20. De préférence, la goulotte 120 comprend une partie accordéon 125, autrement dit une partie élastique et déformable.

Comme illustré sur la figure 5b, un bourrelet 123, avantageusement dans une matière telle qu'un élastomère ou du caoutchouc, est apte à venir épouser l'extérieur de la traverse tubulaire 110 au niveau de son orifice radial 112. Un rebord 124, par exemple conique, avantageusement dans une matière élastique, est apte à venir s'insérer dans l'orifice radial 112 et à empêcher l'extraction de la sortie 122 de la traverse tubulaire 110, au moins sous un effort faible.

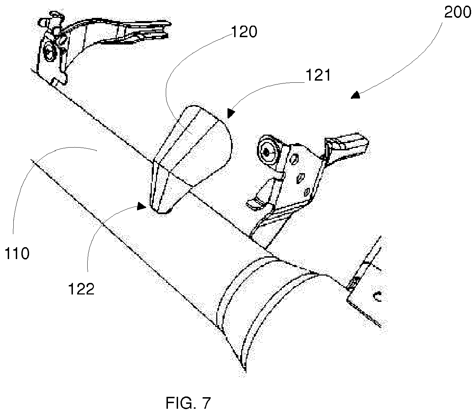

Comme illustré sur les figures 6 et 7, la goulotte 120 a une forme générale de corne ou de coude, son entrée 121 étant avantageusement d'une section supérieure à la section de sa sortie 122.

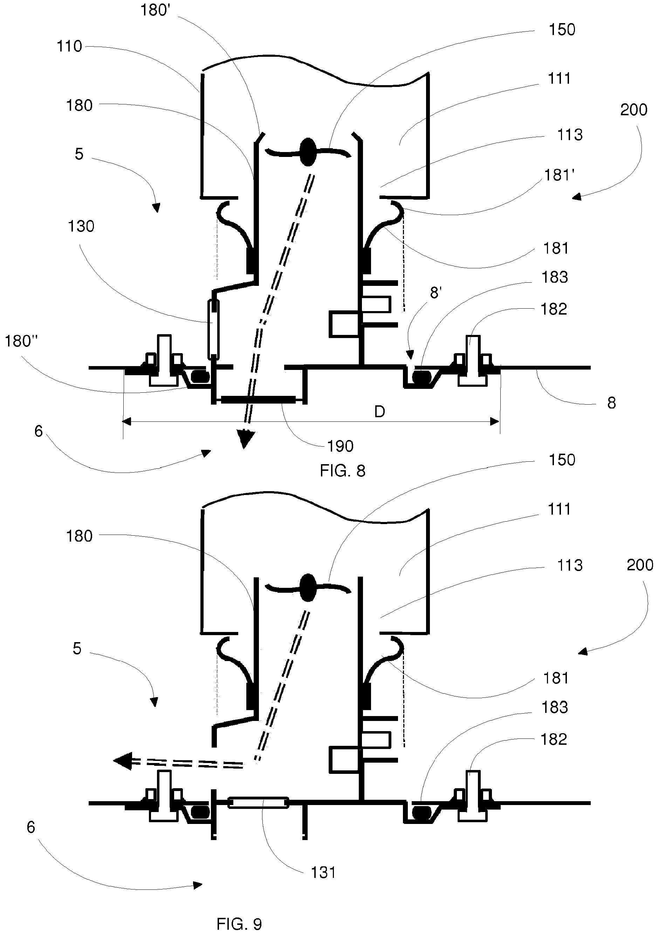

Comme illustré sur la figure 8, l'agencement 200 selon le mode de réalisation comprend un raccord 180 dépourvu d'élément de bifurcation. Ainsi, un bouchon ou capuchon 130 obstrue l'évacuation vers l'habitacle 5. Comme l'illustre la double flèche, seule l'évacuation vers l'extérieur 6 est possible en actionnant le ventilateur 150. A noter qu'un joint d'étanchéité 181, par exemple un joint à lèvre, assure l'étanchéité entre l'extrémité ouverte 113 de la traverse tubulaire 110 et le raccord 180. Le joint d'étanchéité 181 peut être une bague avec un profil courbé ou arrondi pour former un avaloir 181 '. Un joint d'étanchéité 183, par exemple un joint torique, assure quant à lui l'étanchéité entre l'habitacle 5 et l'extérieur 6 situé entre le raccord 180 et la caisse, par exemple le pied avant 8. La fixation du raccord 180 est par exemple assurée par des vis ou rivets 182 sur la caisse, de sorte à comprimer le joint d'étanchéité 183. Dans cette illustration du premier mode de réalisation de l'agencement 200, le raccord 180 au niveau du ventilateur 150 a un diamètre intérieur inférieur au diamètre intérieur de la traverse tubulaire 110. Toutefois, il peut être envisagé que le raccord 180 ait un diamètre intérieur identique ou sensiblement identique au diamètre intérieur de la traverse tubulaire 110. Alternativement, comme illustré sur la figure 9, l'agencement 200 selon une variante du premier mode de réalisation comprend également un raccord 180 dépourvu d'élément de bifurcation. Un bouchon 131 obstrue l'évacuation vers l'extérieur 6. Comme l'illustre la double flèche, seule l'évacuation vers l'habitacle 5 est possible en actionnant le ventilateur 150.

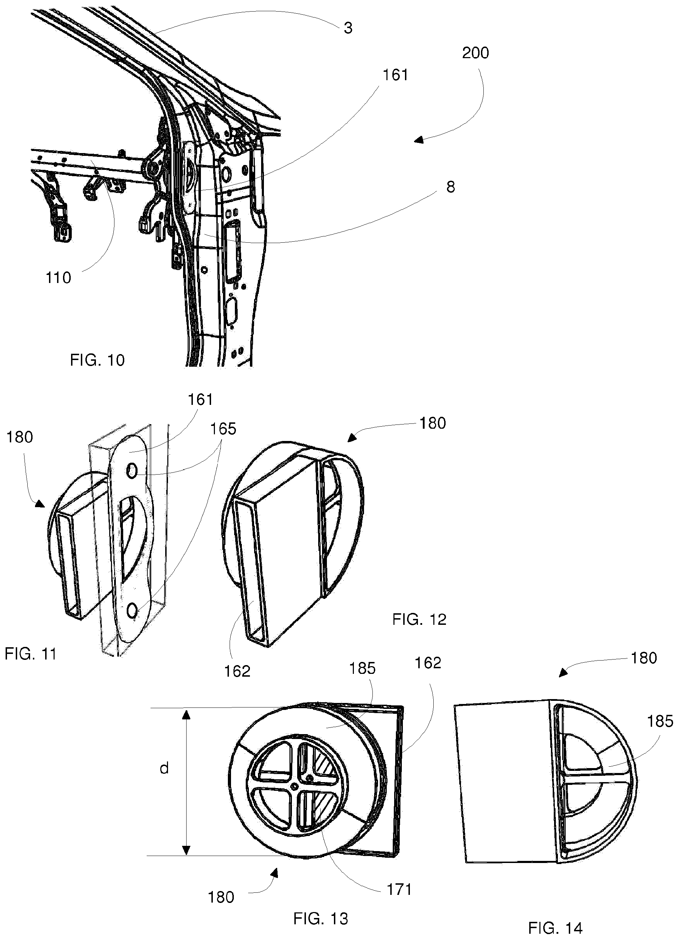

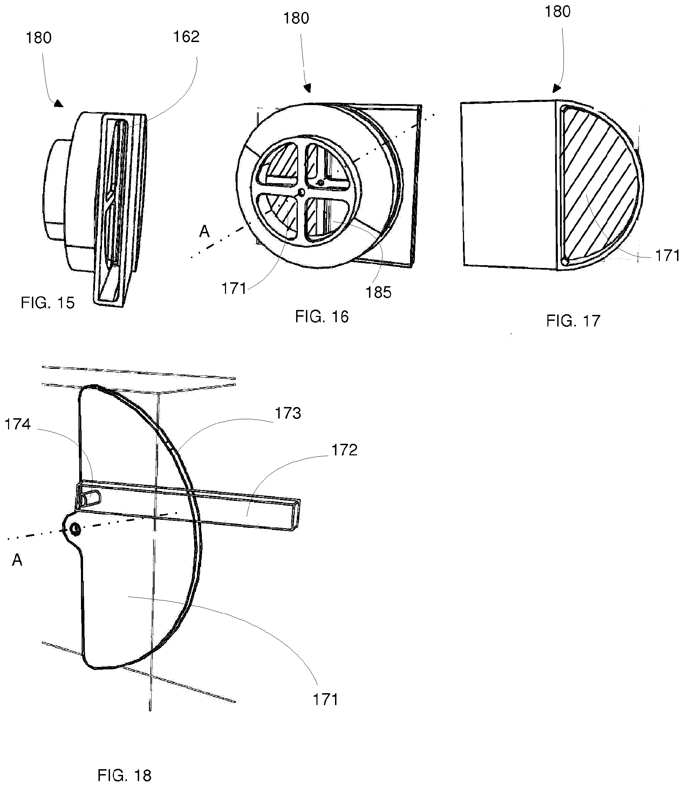

Un deuxième mode de réalisation de l'agencement 200 est illustré sur les figures 10 à 21. Le raccord 180 s'étend alors transversalement sur une faible longueur, autrement dit, le raccord 180 est compact selon la direction transversale. La partie cylindrique 185 du raccord 180 a un diamètre d intérieur de préférence supérieur au diamètre de la traverse 110 de sorte à recevoir un ventilateur 150 de diamètre supérieur au diamètre de la traverse tubulaire 110. Avantageusement, l'élément de bifurcation 170 est intégré dans le raccord 180, à proximité immédiate du ventilateur 150 (non représenté sur les figures 10 à 21), par exemple juste derrière dans le sens de l'écoulement du flux de chaleur. Dans ce deuxième mode de réalisation, le volet 171 est rotatif, son axe de rotation étant coaxial ou sensiblement coaxial à l'axe A du ventilateur 150. Le volet 171 a une forme de palet ou demi-disque comme illustré sur la figure 18. Ainsi le premier diffuseur 161 dispose d'une section d'évacuation sensiblement similaire à la surface du volet 171 et a par conséquent une forme de demi-disque également. Le deuxième diffuseur 162 a quant à lui une section d'évacuation externe de forme rectangulaire alors qu'une section d'évacuation interne est sensiblement similaire à la surface du volet 171. La position du volet 171 illustrée sur les figures 13 et 14 correspond à la position d'évacuation du flux vers l'extérieur 6. La position du volet 171 illustré sur les figures 16 et 17 correspond à la position d'évacuation du flux vers l'habitacle 5. De préférence, le volet 171 est commandé par une bielle ou levier 172 fixé via un ergot 174 sur le volet 171. Des dents aptes à engrener avec un engrenage peuvent aussi être disposées radialement sur la périphérie circulaire 173 du volet 171.

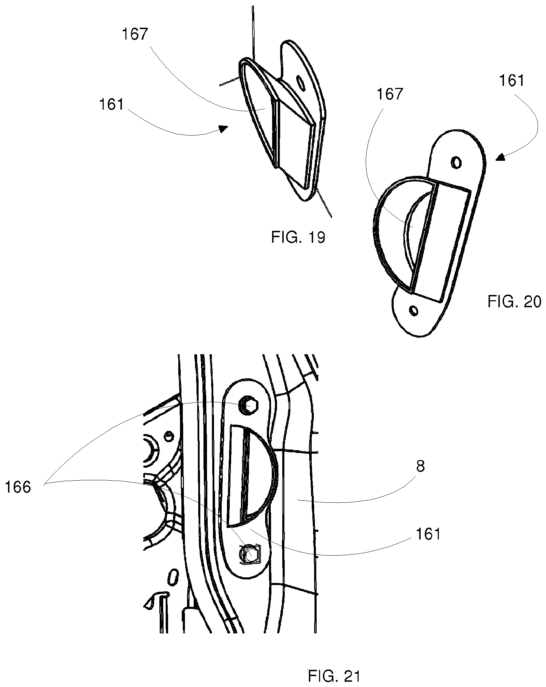

Comme illustré sur les figures 11 et 21, le premier diffuseur 161 peut être fixé sur le pied avant 8 par l'intermédiaire de vis ou rivets 166 traversant des trous 165 ménagés dans le premier diffuseur 161. Un joint d'étanchéité périphérique peut être disposé entre le pied avant 8 et le premier diffuseur 161. Comme illustré sur les figures 19 et 20, la forme intérieure du premier diffuseur 161 peut comprendre un demi-cylindre interne 167, par exemple un demi-cylindre tronqué.

De plus, un procédé d'évacuation de la chaleur produite par le boîtier 20 de l'agencement 200 comprend une étape E0 de mesure de la température du boîtier 20. En cas de température atteignant ou dépassant une valeur seuil, alors le ventilateur 150 est actionné de sorte à créer un flux dans le volume intérieur 111 de la traverse tubulaire 110 et évacuer la chaleur du boîtier 20.

En outre, le procédé d'évacuation comprend une étape E5 de détermination d'une requête de refroidissement ou d'une requête de chauffage faite au sein de l'habitacle 5. En cas de requête de refroidissement, alors le volet 171 de l'élément de bifurcation 170 s'ouvre en vis-à-vis ou sensiblement en vis-à-vis du premier diffuseur 161. En cas de requête de chauffage, alors le volet 171 de l'élément de bifurcation 170 s'ouvre en vis-à-vis ou sensiblement en vis-à-vis du deuxième diffuseur 162.

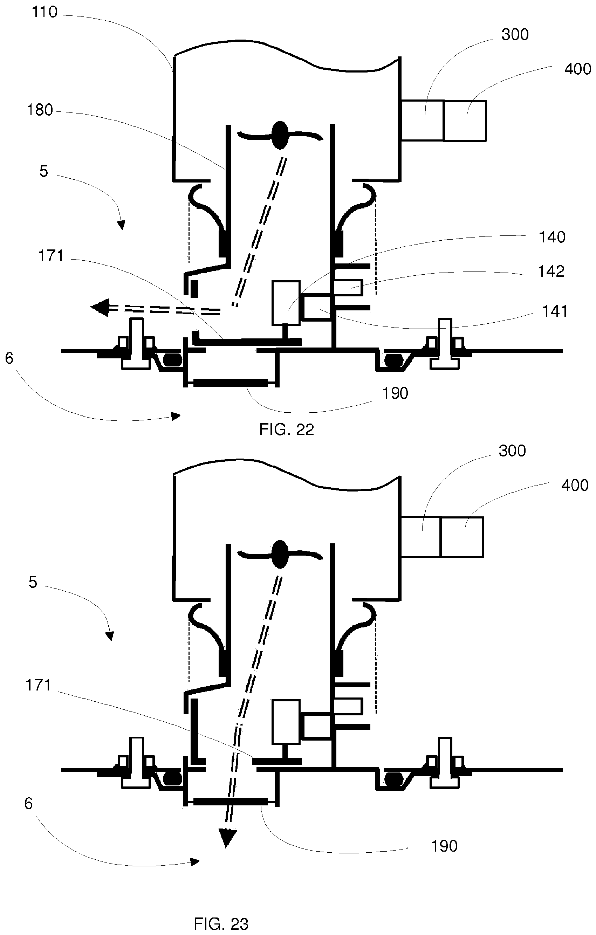

Comme illustré sur les figures 22 et 23 d'une autre variante du premier mode de réalisation, l'agencement 200 comprend des éléments matériels et/ou logiciels 300, 400 mettant en oeuvre les étapes de ce procédé. Un produit programme d'ordinateur téléchargeable depuis un réseau de communication et/ou enregistré sur un support de données 300 lisible par un calculateur 400 et/ou exécutable par le calculateur 400 comprend des instructions de code de programme informatique de mise en oeuvre de tout ou partie des étapes de ce procédé, lorsque le programme est exécuté par le calculateur 400. Le support d'enregistrement de données 300, lisible par le calculateur 400, sur lequel est enregistré le programme d'ordinateur, comprend des instructions de code de programme de mise en oeuvre d'un de ces procédés.

Ainsi, le volet 171 peut être automatisé afin de permettre soit d'évacuer la chaleur vers l'habitacle 5, comme illustré sur la figure 22, soit d'évacuer la chaleur vers l'extérieur 6, comme illustré sur la figure 23. Pour ce faire, un moteur et/ou actionneur 140, complété éventuellement par des moyens de transmission d'énergie électrique ou de connectique 142 et/ou des moyens de transmission d'informations 141, peut être prévu.

En résumé, lorsque le boîtier électrique et/ou électronique 20 produit de la chaleur, le ventilateur 150 peut être démarré. Le ventilateur 150 peut être actionné dès le démarrage du véhicule automobile 1 par exemple ou, de préférence, uniquement en cas de mesure d'une température du boîtier 20 dépassant la valeur seuil prédéfinie. Une ou plusieurs entrée d'air 22 au niveau du boîtier 20 permet à de l'air d'accéder au sein du boîtier 20, de le parcourir au moins en partie pour le refroidir, et de ressortir par une sortie d'air 21 du boîtier 20. La goulotte 120 est alors traversée par l'air chaud provenant de la sortie 21 du boîtier, depuis l'entrée 121 de la goulotte 120 vers sa sortie 122. A la sortie 122 de la goulotte 120, l'air chaud parvient dans le volume intérieur 111 de la traverse tubulaire 110 via l'orifice radial 112 et rejoint l'extrémité ouverte 113 de la traverse tubulaire 110 sous l'effet du ventilateur 150, placé au niveau de cette extrémité ouverte 113, et fonctionnant de sorte à aspirer l'air. L'étanchéité étant réalisée entre le boîtier 20 et la goulotte 120, et entre la goulotte 120 et la traverse 110, par exemple par le biais de matériaux adaptées au moins au niveau des liaisons comme évoqué précédemment, l'aspiration du ventilateur 150 crée un flux débutant dès l'entrée 22 du boîtier 20. Les calories dégagées par le boîtier 20 sont alors transportées depuis l'intérieur du boîtier 20 jusqu'au ventilateur 150. Le boîtier 20 est alors refroidi ce qui évite qu'il ne dysfonctionne ou encore qu'il se mette en défaut ou en mode dégradé à cause d'une température trop élevée. Une fois le ventilateur 150 franchi, le flux d'air chaud est évacué soit uniquement à l'extérieur 6 après avoir traversé le premier diffuseur 161, soit uniquement vers l'habitacle 5 après avoir traversé le deuxième diffuseur 162, soit au choix en fonction des besoins dans l'habitacle comme évoqué précédemment.

Ainsi, le calculateur est relié par au moins un moyen de communication à un ou plusieurs actionneurs pour transmettre des ordres d'actionnement ou non du ventilateur et/ou d'actionnement du volet 171, voire de plusieurs volets en cas de plusieurs sorties de la traverse tubulaire.

Avantageusement, l'agencement 200 comprend davantage de boîtiers 20 associés à des goulottes 120 respectives et des orifices radiaux 112 respectifs dans la traverse tubulaire 110. Une seule traverse tubulaire 110, un seul ventilateur 150, et a fortiori une seule alimentation pour ce ventilateur, permet alors de refroidir plusieurs boîtiers 20. Avantageusement, chaque boîtier 20 peut être muni d'une sonde de température pour pouvoir mesurer la température de chaque boîtier, l'actionnement du ventilateur 150 pouvant se faire par exemple dès l'atteinte d'une température seuil prédéfinie pour un seul des boîtiers 20.

De préférence, le premier diffuseur 161 est recouvert du clapet anti-retour 190 de sorte à permettre uniquement le passage d'un flux d'air vers l'extérieur 6 et à empêcher le passage d'air ou d'eau depuis l'extérieur 6 vers le premier diffuseur 161, voire plus loin, par exemple jusqu'au volume intérieur 111 de la traverse tubulaire 110. Ceci pourrait causer de la corrosion ou encore des dysfonctionnements de l'élément de bifurcation 170 et/ou du ventilateur 150.

Ainsi, le volume intérieur 111 du ou des tubes creux constituant la traverse tubulaire 110 est désormais exploité. Il est nul besoin de recourir à un conduit d'évacuation 110' spécifique, ce qui se traduit par un gain en termes d'encombrement non négligeable au sein de la planche de bord 2 fortement encombrée.

A noter qu'en cas d'absence d'un boîtier, du fait d'un montage optionnel du boîtier par exemple, un obturateur, par exemple de type capuchon ou bouchon, est disposé dans l'orifice radial correspondant de la traverse tubulaire 110. L'étanchéité de cet orifice radial inutilisé est alors assurée et il n'y pas de perte de charge à ce niveau, ou bien des pertes de charge négligeables pour le flux d'extraction de la ou des autres goulottes reliées aux boîtiers 20. Un tel obturateur peut être réalisé en matière type élastomère ou caoutchouc, afin d'éviter toutes vibrations du bouchon sur la traverse tubulaire qui pourrait engendrer du bruit. Alternativement, l'obturateur peut être réalisé en deux matières, par exemple le corps en plastique (type PPTD20) et par exemple une matière élastomère pour une partie bourrelet assurant la fonction de joint. La partie bourrelet peut être une pièce indépendante, par exemple un joint monté sur le corps de l'obturateur réalisé en plastique, ou encore être directement surmoulée sur le corps de l'obturateur via l'outillage utilisé pour la fabrication par injection.

Pour les mêmes raisons d'optimisation de l'écoulement du flux au sein de la traverse tubulaire 110, l'autre extrémité 114 de la traverse tubulaire 110 est de préférence fermée de manière étanche. Avantageusement, les seuls orifices ou trous présents dans la traverse tubulaire 110 sont les orifices radiaux 112 et l'extrémité ouverte 113. Ainsi, en dehors de ces ouvertures, la traverse tubulaire 110 est étanche ou sensiblement étanche.

A noter que l'agencement 200 du premier mode de réalisation illustré sur la figure 8, et l'agencement 200 d'une variante du premier mode de réalisation illustré sur la figure 9 sont davantage aisés à réaliser. En outre, ils sont moins onéreux, en particulier du fait de l'absence d'élément de bifurcation ce qui diminue le nombre de pièces à fabriquer et à assembler. Seul un bouchon 130, 131 doit être installé. Le premier mode de réalisation de l'agencement 200 permet d'évacuer de la chaleur du ou des boîtiers 20, et par conséquent de la planche de bord 2 vers l'extérieur 6, ce qui permet d'éviter que cette chaleur ne se propage à l'habitacle. Cette variante du premier mode de réalisation de l'agencement 200 permet de transférer les calories produites par le ou les boîtiers 20 au sein de l'habitacle. Ainsi, le premier mode de réalisation de l'agencement 200 évoqué ci-dessus et cette variante peuvent par exemple équiper des véhicules automobiles d'entrée de gamme.

L'agencement 200 d'une autre variante, illustrée sur les figures 22 et 23, du premier mode de réalisation offre une réelle optimisation, par exemple en fonction de la température d'au moins un boîtier et/ou en fonction de la température au sein de l'habitacle comme évoqué précédemment, et/ou en fonction de la température extérieure et/ou en fonction de la température du flux d'air chaud émanant du ou des boîtiers 20. L'actionneur 140 peut alors être asservi en fonction d'au moins une de ces températures pour gérer la position du volet 171 de l'élément de bifurcation 170, entre une position permettant d'évacuer vers l'extérieur 6, une position permettant d'évacuer vers l'habitacle 5, voire éventuellement une position intermédiaire évacuant à la fois vers l'extérieur 6 et vers l'habitacle 5.

A noter que le raccord 180 de l'agencement 200 du deuxième mode de réalisation illustré aux figures 10 à 17 permet d'avoir un ventilateur 150 d'un diamètre supérieur au diamètre de la traverse tubulaire afin d'améliorer l'efficacité d'extraction d'air chaud, en d'autres termes d'augmenter son débit. Dans ce cas, le premier diffuseur 161 est fixé sur la caisse du véhicule automobile, par exemple sur le pied 8, et est séparé de la partie cylindrique 185 du raccord 180 destinée à recevoir le ventilateur 150. Ainsi, plusieurs ordres de montage sont envisageables :
- d'abord le montage du raccord 180 par l'intérieur de l'habitacle 5 puis montage du premier diffuseur 161 par l'extérieur de l'habitacle 5, ou
- d'abord le montage du premier diffuseur 161 par l'extérieur de l'habitacle 5 puis montage du raccord 180 par l'intérieur de l'habitacle.

Pour chaque ordre de montage, il faut évidemment que le sens d'insertion des pièces soit compatible avec les éléments destinés à assurer l'étanchéité et/ou permettre un tuilage ou chevauchement des pièces adapté.

Concernant cette question de montage pour le premier mode de réalisation de l'agencement 200, comme illustré sur la figure 8, le joint d'étanchéité 181 peut être doté de l'avaloir 181' afin de faciliter l'insertion à travers le pied avant 8. De même, le raccord 180 peut être doté d'une partie conique 180' facilitant son insertion dans la traverse tubulaire 110. Le joint d'étanchéité 181 permet en outre de rattraper des écarts ou dispersions d'alignement entre le raccord 180 et l'extrémité ouverte 113 de la traverse tubulaire 110. Ainsi, le raccord 180 peut être installé en étant inséré en partie à travers le pied avant 8, depuis l'extérieur 6 vers l'intérieur, seule une partie de fixation 180" destinée au placement du joint 183 et des moyens de fixations 182 étant de dimension D supérieure à l'ouverture 8' faite dans le pied avant 8.

En remarque, la goulotte 120 comprend une entrée 121, une sortie 122 et une partie accordéon 125 spécifiques, comme cela a été exposé précédemment. Ceci afin de permettre de compenser et/ou rattraper des dispersions de positionnement et/ou des défauts d'alignement entre le boîtier 20 et l'orifice radial 112, tout en conservant une parfaite étanchéité, gage d'un débit optimum du flux de chaleur.

La solution est particulièrement adaptée au refroidissement d'un boîtier électrique et/ou électronique au sein de la planche de bord de véhicule automobile et présente les avantages suivants :
- l'agencement 200 étant particulièrement compact, l'espace E au sein de la planche de bord 2 est davantage disponible et peut ainsi recevoir d'autres pièces,
- le volume de l'habitacle 5 n'est pas impacté,
- le volume d'une éventuelle boîte à gants demeure inchangé,
- un seul ventilateur est requis et peut refroidir plusieurs boîtiers engendrant là encore un gain de place et un gain économique,
- ne nécessitant pas son propre ventilateur, chaque boîtier peut voir son volume et sa masse diminués,
- les éventuels obturateurs de la traverse tubulaire 110, les éventuels bouchons 130, 131, ou encore la ou les goulottes 120 sont des pièces peu coûteuses et légères ce qui n'engendre que peu de surcoût et un surpoids négligeable.

A noter que cette solution peut être adaptée à d'autres véhicules tels que par exemple des bateaux, avions, poids-lourds, ou encore blindés comportant une traverse de planche de bord creuse pouvant servir de conduit d'évacuation d'air chaud provenant de boîtiers électriques / électroniques.

## Revendications

1. Dispositif d'évacuation (100) de la chaleur émise par au moins un boîtier électrique et/ou électronique (20) implanté au niveau d'une planche de bord (2) de véhicule automobile, le dispositif d'évacuation (100) comprenant un ventilateur (150) et un conduit d'évacuation (110') doté d'au moins un orifice radial (112) de sorte à permettre l'entrée de la chaleur émise par au moins un boîtier électrique et/ou électronique (20) au sein d'un volume intérieur (111) du conduit d'évacuation (110'), un flux d'air parcourant tout ou partie du volume intérieur (111) du conduit d'évacuation (110') sous l'effet du ventilateur (150) de sorte à extraire la chaleur, notamment à extraire la chaleur par une extrémité ouverte (113) du conduit d'évacuation (110'), **caractérisé en ce que** le dispositif d'évacuation (100) comprend un premier diffuseur (161) agencé au niveau de l'extrémité ouverte (113) du conduit d'évacuation (110') de sorte à permettre la diffusion de la chaleur à l'extérieur (6) d'un véhicule automobile (1), un deuxième diffuseur (162) agencé au niveau de l'extrémité ouverte (113) du conduit d'évacuation (110') de sorte à permettre la diffusion de la chaleur au sein d'un habitacle (5) du véhicule automobile (1) et un élément de bifurcation (170) apte à orienter le flux d'air depuis le volume intérieur (111) du conduit d'évacuation (110') vers le premier diffuseur (161) et/ou vers le deuxième diffuseur (162), en fonction des besoins dans l'habitacle.

2. Dispositif d'évacuation (100) selon la revendication précédente, **caractérisé en ce que** le premier diffuseur (161) comprend un clapet anti-retour (190), notamment un clapet anti-retour de type volet, de sorte à permettre uniquement un flux d'air depuis le volume intérieur (111) du conduit d'évacuation (110') vers l'extérieur (6).

3. Dispositif d'évacuation (100) selon l'une quelconque des revendications précédentes, **caractérisé en ce que** l'élément de bifurcation (170) comprend au moins un volet (171).

4. Agencement (200) au niveau d'une planche de bord (2) de véhicule automobile comprenant une traverse tubulaire (110), notamment une traverse tubulaire (110) s'étendant ou s'étendant sensiblement depuis un montant droit (3) de pare-brise (4) jusqu'à un montant gauche de pare-brise, **caractérisé en ce que** l'agencement (200) comprend un dispositif d'évacuation (100) selon l'une des revendications 1 à 3 et **en ce que** la traverse tubulaire (110) fait office de conduit d'évacuation (110').

5. Agencement (200) selon la revendication 4, **caractérisé en ce qu'**il comprend un raccord (180) s'étendant transversalement ou sensiblement transversalement dans le prolongement de la traverse tubulaire (110) depuis l'extrémité ouverte (113) de la traverse tubulaire (110) jusqu'au premier diffuseur (161), ou sensiblement jusqu'au un premier diffuseur (161), notamment un raccord (180) recevant l'élément de bifurcation (170).

6. Agencement (200) selon la revendication précédente, **caractérisé en ce que** le ventilateur (150) est disposé au sein de la traverse tubulaire (110) et/ou au sein du raccord (180) et/ou au sein de l'élément de bifurcation (170).

7. Agencement (200) selon l'une des revendications 4 à 6, **caractérisé en ce qu'**il comprend au moins un boîtier électrique et/ou électronique (20) et au moins une goulotte (120) s'étendant entre au moins un boîtier électrique et/ou électronique (20) et au moins un orifice radial (112) de la traverse tubulaire (110) de sorte à guider la chaleur depuis au moins un boîtier électrique et/ou électronique (20) vers le volume intérieur (111) de la traverse tubulaire (110).

8. Procédé d'évacuation de la chaleur produite par au moins un boîtier électrique et/ou électronique (20) disposé au niveau d'un agencement (200) selon l'une des revendications 4 à 7, **caractérisé en ce que** le procédé comprend une étape (E0) de mesure de la température de au moins un boîtier électrique et/ou électronique (20) et, en cas de température atteignant ou dépassant une valeur seuil, alors le ventilateur (150) est actionné de sorte à créer un flux dans le volume intérieur (111) de la traverse tubulaire (110) et à évacuer la chaleur de l'au moins un boîtier électrique et/ou électronique (20), le procédé comprenant une étape (E5) de détermination d'une requête de refroidissement ou d'une requête de chauffage faite au sein de l'habitacle (5), et
en cas de requête de refroidissement, alors au moins un volet (171) de l'élément de bifurcation (170) s'ouvre en vis-à-vis ou sensiblement en vis-à-vis du premier diffuseur (161), et,
en cas de requête de chauffage, alors l'au moins un volet (171) de l'élément de bifurcation (170) s'ouvre en vis-à-vis ou sensiblement en vis-à-vis du deuxième diffuseur (162).

9. Agencement (200) selon l'une des revendications 4 à 7, **caractérisé en ce qu'**il comprend des éléments matériels et/ou logiciels (300, 400) mettant en oeuvre le procédé selon la revendication 8.

10. Produit programme d'ordinateur téléchargeable depuis un réseau de communication et/ou enregistré sur un support de données (300) lisible par un calculateur (400) et/ou exécutable par un calculateur (400), **caractérisé en ce qu'**il comprend des instructions de code de programme informatique de mise en oeuvre du procédé selon la revendication 8, lorsque le programme est exécuté par un calculateur (400) étant compris dans l'agencement selon la revendication 9.

11. Support d'enregistrement de données (300), lisible par un calculateur (400) étant compris dans l'agencement selon la revendication 9, sur lequel est enregistré un programme d'ordinateur comprenant des instructions de code de programme de mise en oeuvre du procédé selon la revendication 8.

12. Véhicule automobile (1), **caractérisé en ce qu'**il comprend un dispositif d'évacuation (100) selon l'une des revendications 1 à 3 et/ou un agencement (200) selon l'une des revendications 4 à 7 ou 9.

## Patentansprüche

1. Vorrichtung zum Abführen (100) der Wärme, die von mindestens einer elektrischen und/oder elektronischen Einheit (20) abgegeben wird, welche an einem Armaturenbrett (2) eines Kraftfahrzeugs angeordnet ist, wobei die Vorrichtung zum Abführen (100) einen Lüfter (150) umfasst, und einen Abführkanal (110'), der mit mindestens einer radialen Öffnung (112) versehen ist, um den Eintritt der von mindestens einer elektrischen und/oder elektronischen Einheit (20) abgegebenen Wärme in ein Innenvolumen (111) des Abführkanals (110') zu ermöglichen, wobei ein Luftstrom unter der Wirkung des Lüfters (150) das gesamte Innenvolumen (111) des Abführkanals (110') oder einen Teil davon durchströmt, um die Wärme anzuführen, insbesondere um die Wärme über ein offenes Ende (113) des Abführkanals (110') abzuführen, **dadurch gekennzeichnet, dass** die Vorrichtung zum Abführen (100) eine erste Ausströmöffnung (161), die an dem offenen Ende (113) des Abführkanals (110') angeordnet ist, um die Diffusion der Wärme in die äußere Umgebung (6) eines Kraftfahrzeugs (1) zu ermöglichen, eine zweite Ausströmöffnung (162), die an dem offenen Ende (113) des Abführkanals (110') angeordnet ist, um die Diffusion der Wärme innerhalb eines Fahrgastraumes (5) des Kraftfahrzeugs (1) zu ermöglichen, und ein Verzweigungselement (170), das geeignet ist, den Luftstrom aus dem Innenvolumen (111) des Abführkanals (110') in Abhängigkeit vom Bedarf im Fahrgastraum zur ersten Ausströmöffnung (161) und/oder zur zweiten Ausströmöffnung (162) zu lenken, umfasst.

2. Vorrichtung zum Abführen (100) nach dem vorhergehenden Anspruch, **dadurch gekennzeichnet, dass** die erste Ausströmöffnung (161) ein Rückschlagventil (190), insbesondere ein Klappenrückschlagventil, umfasst, um ausschließlich einen Luftstrom aus dem Innenvolumen (111) des Abführkanals (110') zur äußeren Umgebung (6) zu ermöglichen.

3. Vorrichtung zum Abführen (100) nach einem der vorhergehenden Ansprüche, **dadurch gekennzeichnet, dass** das Verzweigungselement (170) mindestens eine Klappe (171) umfasst.

4. Anordnung (200) an einem Armaturenbrett (2) eines Kraftfahrzeugs, welche einen rohrförmigen Querträger (110) umfasst, insbesondere einen rohrförmigen Querträger (110), der sich von einem rechten Pfosten (3) der Windschutzscheibe (4) bis zu einem linken Pfosten der Windschutzscheibe erstreckt oder im Wesentlichen erstreckt, **dadurch gekennzeichnet, dass** die Anordnung (200) eine Vorrichtung zum Abführen (100) nach einem der Ansprüche 1 bis 3 umfasst, und dadurch, dass der rohrförmige Querträger (110) als Abführkanal (110') dient.

5. Anordnung (200) nach Anspruch 4, **dadurch gekennzeichnet, dass** sie ein Anschlussstück (180) umfasst, dass sich in der Verlängerung des rohrförmigen Querträgers (110) in Querrichtung oder im Wesentlichen in Querrichtung von dem offenen Ende (113) des rohrförmigen Querträgers (110) bis zu der ersten Ausströmöffnung (161) oder im Wesentlichen bis zu einer ersten Ausströmöffnung (161) erstreckt, insbesondere ein Anschlussstück (180), welches das Verzweigungselement (170) aufnimmt.

6. Anordnung (200) nach dem vorhergehenden Anspruch, **dadurch gekennzeichnet, dass** der Lüfter (150) innerhalb des rohrförmigen Querträgers (110) und/oder innerhalb des Anschlussstücks (180) und/oder innerhalb des Verzweigungselements (170) angeordnet ist.

7. Anordnung (200) nach einem der Ansprüche 4 bis 6, **dadurch gekennzeichnet, dass** sie mindestens eine elektrische und/oder elektronische Einheit (20) und mindestens eine Rinne (120), die sich zwischen mindestens einer elektrischen und/oder elektronischen Einheit (20) und mindestens einer radialen Öffnung (112) des rohrförmigen Querträgers (110) erstreckt, um die Wärme von mindestens einer elektrischen und/oder elektronischen Einheit (20) zu dem Innenvolumen (111) des rohrförmigen Querträgers (110) zu leiten, umfasst.

8. Verfahren zum Abführen der Wärme, die von mindestens einer elektrischen und/oder elektronischen Einheit (20) erzeugt wird, die an einer Anordnung (200) nach einem der Ansprüche 4 bis 7 angeordnet ist, **dadurch gekennzeichnet, dass** das Verfahren einen Schritt (E0) der Messung der Temperatur von mindestens einer elektrischen und/oder elektronischen Einheit (20) umfasst und im Falle einer Temperatur, die einen Schwellenwert erreicht oder überschreitet, dann der Lüfter (150) in Gang gesetzt wird, um eine Strömung im Innenvolumen (111) des Abführkanals (110) zu erzeugen und die Wärme von der mindestens einen elektrischen und/oder elektronischen Einheit (20) abzuführen, wobei das Verfahren einen Schritt (E5) der Bestimmung einer Kühlanforderung oder Heizanforderung umfasst, die innerhalb des Fahrgastraumes (5) erfolgt, und
im Falle einer Kühlanforderung sich dann mindestens eine Klappe (171) des Verzweigungselements (170) gegenüber oder im Wesentlichen gegenüber der ersten Ausströmöffnung (161) öffnet und
im Falle einer Heizanforderung sich dann mindestens eine Klappe (171) des Verzweigungselements (170) gegenüber oder im Wesentlichen gegenüber der zweiten Ausströmöffnung (162) öffnet.

9. Anordnung (200) nach einem der Ansprüche 4 bis 7, **dadurch gekennzeichnet, dass** sie Hardware- und/oder Softwareelemente (300, 400) umfasst, die das Verfahren nach Anspruch 8 durchführen.

10. Computerprogrammprodukt, welches aus einem Kommunikationsnetz herunterladbar und/oder auf einem von einem Rechner (400) lesbaren Datenträger (300) aufgezeichnet und/oder von einem Rechner (400) ausführbar ist, **dadurch gekennzeichnet, dass** es Programmcodeanweisungen zur Durchführung des Verfahrens nach Anspruch 8, wenn das Programm von einem in der Anordnung nach Anspruch 9 enthaltenen Rechner (400) ausgeführt wird, umfasst.

11. Datenspeicherträger (300), der von einem in der Anordnung nach Anspruch 9 enthaltenen Rechner (400) lesbar ist und auf dem ein Computerprogramm aufgezeichnet ist, das Programmcodeanweisungen zur Durchführung des Verfahrens nach Anspruch 8 umfasst.

12. Kraftfahrzeug (1), **dadurch gekennzeichnet, dass** es eine Vorrichtung zum Abführen (100) nach einem der Ansprüche 1 bis 3 und/oder eine Anordnung (200) nach einem der Ansprüche 4 bis 7 oder 9 umfasst.

## Claims

1. Device (100) for discharging the heat emitted by at least one electrical and/or electronic unit (20) installed in a motor vehicle dashboard (2), the discharge device (100) comprising a fan (150) and a discharge duct (110') provided with at least one radial orifice (112) so as to allow the heat emitted by at least one electrical and/or electronic unit (20) to enter an interior volume (111) of the discharge duct (110'), an air flow passing through all or part of the interior volume (111) of the discharge duct (110') under the effect of the fan (150), so as to extract the heat, notably to extract the heat via an open end (113) of the discharge duct (110'), **characterized in that** the discharge device (100) comprises a first diffuser (161) arranged at the open end (113) of the discharge duct (110') so as to allow the heat to be diffused to the outside (6) of a motor vehicle (1), a second diffuser (162) arranged at the open end (113) of the discharge duct (110') so as to allow the heat to be diffused into an interior compartment (5) of the motor vehicle (1) and a junction element (170) able to orient the air flow from the interior volume (111) of the discharge duct (110') towards the first diffuser (161) and/or towards the second diffuser (162), depending on the requirements in the vehicle interior compartment.

2. Discharge device (100) according to the preceding claim, **characterized in that** the first diffuser (161) comprises a nonreturn valve (190), notably a nonreturn valve of the shutter type, so as to allow an air flow only from the interior volume (111) of the discharge duct (110') towards the outside (6).

3. Discharge device (100) according to any one of the preceding claims, **characterized in that** the junction element (170) comprises at least one shutter (171).

4. Arrangement (200) in a motor vehicle dashboard (2) comprising a tubular crossmember (110), notably a tubular crossmember (110) extending or substantially extending from a right-hand A-pillar (3) supporting a windscreen (4) as far as a left-hand A-pillar, **characterized in that** the arrangement (200) comprises a discharge device (100) according to one of Claims 1 to 3 and **in that** the tubular crossmember (110) acts as a discharge duct (110').

5. Arrangement (200) according to Claim 4, **characterized in that** it comprises a connector (180) extending transversely or substantially transversely in the continuation of the tubular crossmember (110) from the open end (113) of the tubular crossmember (110) as far as the first diffuser (161) or substantially as far as a first diffuser (161), notably a connector (180) accepting the junction element (170).

6. Arrangement (200) according to the preceding claim, **characterized in that** the fan (150) is positioned within the tubular crossmember (110) and/or within the connector (180) and/or within the junction element (170).

7. Arrangement (200) according to one of Claims 4 to 6, **characterized in that** it comprises at least one electrical and/or electronic unit (20) and at least one channel (120) extending between at least one electrical and/or electronic unit (20) and at least one radial orifice (112) of the tubular crossmember (110) so as to guide the heat from at least one electrical and/or electronic unit (20) towards the interior volume (111) of the tubular crossmember (110) .

8. Method for discharging the heat produced by at least one electrical and/or electronic unit (20) arranged in an arrangement (200) according to one of Claims 4 to 7, **characterized in that** the method comprises a step (E0) of measuring the temperature of at least one electrical and/or electronic unit (20) and, if the temperature reaches or exceeds a threshold value, then the fan (150) is actuated so as to create a flow in the interior volume (111) of the tubular crossmember (110) and remove the heat from the at least one electrical and/or electronic unit (20), the method comprising a step (E5) of determining a request for cooling or a request for heating made from within the vehicle interior compartment (5), and
in the event of a request for cooling, then at least one shutter (171) of the junction element (170) opens to face or substantially to face the first diffuser (161), and
in the event of a request for heating, then the at least one shutter (171) of the junction element (170) opens to face or substantially to face the second diffuser (162).

9. Arrangement (200) according to one of Claims 4 to 7, **characterized in that** it comprises hardware and/or software elements (300, 400) implementing the method according to Claim 8.

10. Computer program product that can be downloaded from a communications network and/or saved on a data medium (300) that can be read by a computer processor (400) and/or that can be executed by a computer processor (400), **characterized in that** it comprises computer program code instructions for carrying out the method according to Claim 8 when the program is run by a computer processor (400) comprised within the arrangement according to Claim 9.

11. Data recording medium (300) that can be read by a computer processor (400) comprised within the arrangement according to Claim 9 and on which there is saved a computer program comprising program code instructions for implementing the method according to Claim 8.

12. Motor vehicle (1), **characterized in that** it comprises a discharge device (100) according to one of Claims 1 to 3 and/or an arrangement (200) according to one of Claims 4 to 7 or 9.
